# EUROPÄISCHE PATENTSCHRIFT

(11) **EP 0 432 528 B1**
(45) Veröffentlichungstag und Bekanntmachung des Hinweises auf die Patenterteilung: **23.03.1994**
(21) Anmeldenummer: 90122260.4
(22) Anmeldetag: 22.11.1990
(51) Int. Cl.: C23C 14/32, H01J 37/32, C23C 14/06

(54) **Verfahren zur Erzeugung von Schichten aus harten Kohlenstoffmodifikationen und Vorrichtung zur Durchführung des Verfahrens**
Process for the production of hard carbon layers and apparatus for carrying out the process
Procédé pour la production de couches en carbone dur et appareillage pour sa réalisation

(30) Priorität: 14.12.1989 DE 3941202
(43) Veröffentlichungstag der Anmeldung: 19.06.1991
(73) Patentinhaber: Fried. Krupp AG Hoesch-Krupp, 45143 Essen (DE)
(72) Erfinder: Buck, Volker, Prof. Dr., W-5620 Velbert 11 (DE); Schlump, Wolfgang, Dr. rer. nat., W-4300 Essen 1 (DE); Willbrand, Jürgen, Dipl.-Chem., W-4300 Essen 1 (DE)

(56) Entgegenhaltungen:
- EP-A- 0 158 972
- US-A- 3 931 542
- JAPANESE JOURNAL OF APPLIED PHYSICS, Band 27, Nr. 9, September 1988, Seiten L1600-L1602; F. AKATSUKA et al.: "Rapid growth of diamond films by arc discharge plasma CVD"
- PATENT ABSTRACTS OF JAPAN, Band 13, Nr. 107 (C-576)[3455], 14. März 1989; & JP-A-63 282 199

## Beschreibung

Die Erfindung betrifft ein Verfahren zur Erzeugung von Schichten aus harten Kohlenstoffmodifikationen, insbesondere Diamantschichten, unter Einsatz eines Kohlenstoff enthaltenden Mittels mittels eines unter Vakuum zwischen zwei Elektroden gezündeten Gleichstrom-Lichtbogens, dem Wasserstoff zugeführt wird. Gegenstand der Erfindung ist ferner eine zur Durchführung des Verfahrens geeignete Vorrichtung mit einer eine Unterdruckquelle aufweisenden Reaktionskammer, in der ein Elektrodenpaar zur Erzeugung eines Gleichstrom-Lichtbogens und einer Halterung für ein zu beschichtendes Substrat angeordnet sind, und mit einer Gaszuführung, über welche dem Lichtbogen Wasserstoff zuführbar ist.

Bei einem Verfahren und einer Vorrichtung der eingangs genannten Gattung - vorbeschrieben in der Zeitschrift "Japanese Journal of Applied Physics", Vol 27, No. 9, September, 1988, pp. L1600 bis L1602 - dienen die in einer evakuierten Reaktionskammer angeordneten Elektroden ausschließlich zur Erzeugung eines Lichtbogens. In diesen wird über eine Gaszuführung außerhalb des Bereichs der Elektroden Mischgas eingeleitet, welches sich aus Wasserstoff und Argon sowie aus Äthanol als Kohlenstoff enthaltendem Mittel zusammensetzt. Das zu beschichtende Substrat ist auf einer Halterung unterhalb des zwischen den Elektroden gezündeten Gleichstrom-Lichtbogens angeordnet. Der Nachteil dieses bekannten Verfahrens besteht darin, daß bei Verwendung gasförmiger Kohlenwasserstoffe Kohlenstoff und Wasserstoff gekoppelt auftreten und im Verfahren nicht völlig unabhängig voneinander variierbar sind; das gleiche gilt bei Verwendung von Äthanol auch für Sauerstoff. Weiterhin ist durch die externe Gaszuführung ein erhöhter Anteil an neutralen Gasen vorhanden.

Aus der deutschen Patentschrift 34 13 891 sind ein Verfahren und eine Vorrichtung zur Materialverdampfung in einem Vakuumbehälter bekannt, die mit einer unter Einwirkung eines Gleichstrom-Lichtbogens verdampfenden Anode ausgestattet sind. Beide Elektroden können aus Graphit bestehen bzw. zumindest mit Graphit beschichtet sein. Die Kathode weist in dem der Anode zugewandten Bereich einen erheblich größeren Durchmesser auf als diese.
Im Gegensatz zu dem zuvor beschriebenen Stand der Technik wird die Vakuumbogenentladung im wesentlichen durch die verdampfenden Anodenbestandteile als Brennmaterial aufrechterhalten. Oberhalb des Elektrodenpaares, also außerhalb des Bereichs des Lichtbogens, ist ein das Substrat aufnehmender Aufdampfraum vorhanden, in dem erforderlichenfalls eine den Aufdampfvorgang beeinflussende reaktive Gasatmosphäre aufrechterhalten wird. Der Nachteil des in Rede stehenden Lösungsvorschlags besteht darin, daß mit dem beschriebenen Vakuumlichtbogen nicht der bzw. die für die Herstellung von Diamantschichten notwendige atomare Wasserstoff und/oder H⁺-Ionen in ausreichender Menge erzeugt werden kann bzw. können.

Der Erfindung liegt die Aufgabe zugrunde, ein Verfahren und eine zur Durchführung des Verfahrens geeignete Vorrichtung anzugeben, welche es ermöglichen, bei Schichtbildungsgeschwindigkeiten in der Größenordnung von einem Mikrometer/Minute diamantähnliche Schichten, vor allem jedoch Diamantschichten herzustellen.

Die gestellte Aufgabe wird durch ein Verfahren mit den Merkmalen des Anspruchs 1 gelöst. Der der Erfindung zugrundeliegende Lösungsgedanke besteht darin, den für die Erzeugung der harten Kohlenstoffmodifikationen benötigten Wasserstoff durch zumindest eine der beiden Elektroden unmittelbar dem Bereich des Lichtbogens zuzuführen und diesen gleichzeitig über die Anode mit Kohlenstoff zu speisen.
Dieser Lösungsvorschlag unterscheidet sich vom eingangs beschriebenen Stand der Technik dadurch, daß bei zusätzlicher Zuführung von Wasserstoff unmittelbar in den Bereich des Lichtbogens unter Bildung von atomarem Wasserstoff und/oder H⁺-Ionen von der sich aufzehrenden Anode Kohlenstoff eingespeist wird.
Es liegt somit weder der Fall vor, daß die Reaktionsstoffe ausschließlich über die Gaszuführung in den Bereich des Lichtbogens eingeleitet werden (Gegenstand der Zeitschrift), noch der Fall, daß die Reaktionsstoffe lediglich von dem verdampfenden Anodenmaterial geliefert werden (Gegenstand der deutschen Patentschrift). Das Verfahren nach der Erfindung läßt sich dabei - im Hinblick auf die Bildung einer möglichst großen Menge an atomarem Wasserstoff bzw. einer möglichst großen Anzahl H⁺-Ionen pro Zeiteinheit in dreierlei Hinsicht ausführen: entweder erfolgt die Gaszuführung ausschließlich über eine der beiden Elektroden, d.h. die Anode oder die Kathode, oder gegebenenfalls mit unterschiedlichen Anteilen am gesamten Volumenstrom gleichzeitig über beide Elektroden. Zur Einstellung bzw. Aufrechterhaltung ausreichend gleichbleibender Verfahrensbedingungen wird der Elektrodenabstand während des Beschichtungsvorgangs in an sich bekannter Weise nachgeregelt; dies kann dadurch geschehen, daß die Nachführung in Abhängigkeit von den jeweils konkret festgestellten Verfahrensparametern, beispielsweise dem Elektrodenabstand, oder unabhängig davon mit fortschreitender Verfahrensdauer (also rein zeitabhängig) erfolgt.

Die Schichtbildungsgeschwindigkeit läßt sich gegebenenfalls durch eine Verfahrensführung erhöhen, bei welcher der Lichtbogen eine Krümmung in Richtung auf das zu beschichtende Substrat aufweist (Anspruch 2); dieses kann insbesondere aus Metall, Keramik oder Glas bestehen. Weiterhin sollte der Lichtbogen in der Weise eingestellt werden, daß er eine Dissoziationsrate des Wasserstoffs von mindestens 50 % aufweist (Anspruch 3).
Bei einer vorteilhaften Ausgestaltung des Verfahrens wird die Gaszuführung während des Beschichtungsvorgangs derart bemessen, daß der Volumenstrom des insgesamt zugeführten Wasserstoffs zwischen 20 und 2000 cm³/min. beträgt (Anspruch 4); die Zuführung kann dabei insbesondere auch derart eingestellt sein, daß der Volumenstrom eine sich mit der Zeit verändernde Größe aufweist.
Während des Beschichtungsvorgangs werden die Elektroden zweckmäßig in der Weise mit Energie versorgt, daß sie bei einer Spannung zwischen 70 und 24 V von einem Strom in der Größe zwischen 8 und 70 A durchflossen werden (Anspruch 5).
Die Aufrechterhaltung und Steuerung des Lichtbogens läßt sich dadurch vereinfachen, daß die Elektroden mit einer gepulsten Gleichspannung beaufschlagt werden (Anspruch 6); dazu werden der Gleichspannung Wechselspannungsanteile überlagert.

Der Beschichtungsvorgang kann weiterhin dadurch beeinflußt werden, daß dem Wasserstoff vor dem Eintritt in den Lichtbogen die Dissoziationsrate erhöhende Gase beigemischt werden (Anspruch 7), wie beispielsweise Ar. Durch Beimischung von Sauerstoff oder Sauerstoffverbindungen (beispielsweise O₂ bzw. Wasserdampf) läßt sich die Abscheidungsrate erhöhen (Anspruch 8).

Während des Beschichtungsvorgangs sollte das Substrat auf Temperaturen von allenfalls 1000 °C aufgeheizt werden (Anspruch 9).
Insbesondere bei Substraten aus temperaturempfindlichen Werkstoffen kann eine unerwünscht hohe Substrattemperatur dadurch vermieden werden, daß die zu beschichtende Oberfläche des Substrats mit energiereichen Teilchen beschossen wird (Anspruch 10), beispielsweise unter Einsatz einer Ionenquelle.

Das Verfahren kann dadurch weiter ausgestaltet sein, daß die während des Beschichtungsvorgangs zusammenwirkenden Bereiche auf ein unterschiedliches elektrisches Potential gebracht werden. Insbesondere lassen sich die aus dem Lichtbogen austretenden Ionen durch eine in Richtung auf das Substrat wirksame Vorspannung beschleunigen (Anspruch 11). Dies kann dadurch geschehen, daß das Substrat während des Beschichtungsvorgangs auf einem bezüglich der Anode unterschiedlichen Potential gehalten wird (Anspruch 12).

Die eingangs erwähnte Aufgabe wird weiterhin durch eine zur Durchführung des Verfahrens geeignete Vorrichtung mit den Merkmalen des Anspruchs 13 gelöst. Danach besteht zumindest die Anode, die unter Einwirkung des Lichtbogens abgetragen wird, aus Graphit und ist zumindest eine der Elektroden, deren gegenseitiger Abstand über eine Nachregelung zumindest schrittweise aufrechterhalten werden kann, derart ausgebildet, daß der Wasserstoff durch sie hindurch in den Lichtbogen eingeleitet werden kann. Um sicherzustellen, daß vorwiegend die Anode abgetragen wird, weist die Kathode in dem der Anode zugewandten Bereich eine größere Fläche auf als letztere (Anspruch 14); vorzugsweise ist die Fläche der Kathode zumindest um das Dreifache größer als diejenige der Anode.
Der Verfahrensablauf und das Verfahrensergebnis lassen sich dadurch in günstiger Weise beeinflussen, daß zumindest die Anode aus Graphit mit hoher Dichte besteht und derart beschaffen ist, daß ihre Gasabgabe während des Beschichtungsvorgangs gering ist (Anspruch 15). Vorzugsweise werden die Anode und/oder Kathode vor dem Beschichtungsvorgang ausgeheizt (Anspruch 16).

Bei einer vorteilhaften Ausführungsform der Vorrichtung ist zumindest eine der beiden Elektroden mit zumindest einem Gaskanal ausgestattet und über diesen an die Gaszuführung anschließbar (Anspruch 17).
Unter Umständen ist es aus abmessungstechnischen oder fertigungstechnischen Gründen nicht möglich, insbesondere die kleiner bemessene Anode mit einem sie durchziehenden Gaskanal auszustatten. In diesem Falle kann zumindest eine der beiden Elektroden aus mehreren eine Packung bildenden Stäben zusammengesetzt werden, zwischen denen der zumindest eine Gaskanal verläuft (Anspruch 18); eine Elektrode mit einem mittig angeordneten Gaskanal läßt sich in einfacher Weise mittels einer Packung aus drei Stäben mit Kreisquerschnitt herstellen (Anspruch 19).
Durch Zusammensetzen einer Elektrode unter Verwendung einer größeren Anzahl Stäbe lassen sich zwischen diesen ohne großen Aufwand weitere Gaskanäle herstellen, die eine weitergehende Verteilung der Gaszuführung zur Folge haben. Der Vorteil einer derartigen Ausgestaltung ist darin zu sehen, daß die Gaskanäle der betreffenden Elektrode unterschiedlich und/oder mit verschiedenen Gasen (vgl. die Ansprüche 7 und 8) beaufschlagt werden können: beispielsweise kann ein Teil der Gaskanäle der Zuführung von Wasserstoff in den Lichtbogen dienen, während durch andere Gaskanäle hindurch - gegebenenfalls auch nur zeitweilig - beispielsweise Ar bzw. O₂ zugeführt wird.

Der Beschichtungsvorgang läßt sich dadurch vorteilhaft beinflussen, daß die Elektroden zueinander in Richtung auf das Substrat schräggestellt sind (Anspruch 20); bei einer derartigen Ausführungsform schließen die aneinander zugewandten Bereiche der Elektroden - vom Substrat her gesehen - miteinander einen Winkel von mehr als 180 ° ein.

Die eventuell nachteilige Aufheizung des Substrats (im Normalfall auf Temperaturen von mindestens 400 °C) kann dadurch reduziert werden, daß die Reaktionskammer zusätzlich mit einer Teilchenquelle zur Beaufschlagung der Substrat-Oberfläche mit energiereichen Teilchen ausgestattet ist (Anspruch 21).

Bei einer vorteilhaften Weiterbildung der Vorrichtung ist die Gaszuführung an eine Mischeinheit anschließbar, über welche zusätzlich den Beschichtungsvorgang beeinflussende Gase (vgl. dazu Anspruch 7 und/oder 8) beigemischt werden können (Anspruch 22).

Die Erfindung wird nachfolgend anhand der Zeichnung im einzelnen erläutert:
Es zeigen:
- Fig. 1: stark schematisiert den Aufbau einer Vorrichtung zur Erzeugung von Schichten aus harten Kohlenstoffmodifikationen mit einem Vertikalschnitt durch die zugehörige Reaktionskammer,
- Fig. 2a: eine Stirnansicht einer Elektrode, die einen Gaskanal in Gestalt einer Längsbohrung aufweist,
- Fig. 2b,c: eine Stirnansicht einer aus drei bzw. sechs Stäben zusammengesetzten Elektrode, die einen Gaskanal bzw. vier Gaskanäle aufweist, und
- Fig. 3: eine Teilansicht der Anordnung gemäß Fig. 1, wobei die Elektroden zueinander in Richtung auf das Substrat schräggestellt sind.

Einer der Hauptbestandteile der Vorrichtung zur Erzeugung von Schichten aus harten Kohlenstoffmodifikationen ist eine Reaktionskammer 1, in der mittels einer Vakuumpumpe 2 ein ausreichend bemessener Unterdruck hergestellt werden kann. Die Überwachung des in der Reaktionskammer herrschenden Vakuums wird durch ein Unterdruckmeßgerät 3 ermöglicht, welches in der Nähe der Kopfplatte 1a gehalten ist.
Auf der Fußplatte 1b der Reaktionskammer außerhalb des Lichtbogens ist mit Zwischenschaltung elektrischer Isolierungen 4 eine tischförmige Aufnahme 5 befestigt, auf welcher das zu beschichtende Substrat 6 aufliegt. Die Aufnahme ist mit einer Heizeinheit 5a ausgestattet, über welche die Substrattemperatur beeinflußt bzw. geregelt werden kann.

In die Reaktionskammer ragen - sich fluchtend gegenüberliegend - eine Anode 7 und eine Kathode 8 hinein, die über einen nichtdargestellten Nachführantrieb in Richtung des Doppelpfeils 9 bzw. 10 geradlinig verfahrbar sind. Die bewegliche Abstützung der genannten Elektroden 7 und 8 besteht aus Isolierbuchsen 11, die ihrerseits an den Seitenwänden 1c, 1d befestigt sind.
Außerhalb der Reaktionskammer 1 sind die Elektroden 7 und 8 über eine Anschlußklemme 7a bzw. 8a und eine Versorgungsleitung 12 bzw. 13 an eine Energieversorgungseinheit 14 angeschlossen, welche die beiden Elektroden während des Beschichtungsvorgangs mit einer gepulsten Gleichspannung beaufschlagt.
Der der Anode 7 zugewandte Endabschnitt der Kathode 8 ist als scheibenförmige Erweiterung 8a ausgebildet; deren Fläche ist um mehr als das Dreifache größer als der Durchmesser der lediglich stabförmigen Anode 7.
Die Aufnahme 5 kann während des Beschichtungsvorgangs über eine mit der Leitung 13 in Verbindung stehende Leitung 15a auf einem bezüglich der Anode 7 unterschiedlichen Potential gehalten werden. Die Leitung 15a, die über eine als Durchführung dienende Isolierbuchse 16 gegen die Seitenwand 1d isoliert ist, wird von einem Netzgerät 15 aus versorgt; dieses ist seinerseits über eine Leitung 15b an die Leitung 13 angeschlossen.

Jede Elektrode 7, 8 weist einen durch sie hindurchgeführten Gaskanal 7b bzw. 8c auf, der über eine Gasleitung 17 bzw. 18 an eine Gaszuführung angeschlossen ist. Diese besteht aus einem mit Wasserstoff gefüllten Vorratsbehälter 19, der unter Zwischenschaltung jeweils eines Absperrventils 20 bzw. 21 mit der Gasleitung 17 bzw. 18 in Verbindung steht.
Die Gaszuführung umfaßt ferner einen mit Ar gefüllten Vorratsbehälter 22 und einen mit O₂ gefüllten Vorratsbehäler 23. Diese sind über Leitungen 24, 25 bzw. 26, 27 - in die jeweils ein Absperrventil 28, 29, 30 bzw. 31 eingebaut ist - an die Gasleitung 17 bzw. 18 angeschlossen.

Durch Betätigen der Absperrventile 20 und 21 kann der während des Beschichtungsvorgangs über die Gaskanäle 7b und 8c zugeführte Volumenstrom an Wasserstoff in der Weise anteilmäßig aufgeteilt werden, daß die Bildungsrate an atomarem Wasserstoff und/oder H⁺-Ionen im Lichtbogen zwischen den Elektroden 7 und 8 einen möglichst großen Wert annimmt.
Erforderlichenfalls kann durch Öffnen der Absperrventile 28 und 29 bzw. 30 und 31 der Verfahrensablauf dadurch beeinflußt werden, daß dem Wasserstoff vor dem Eintritt in den Lichtbogen zur Erhöhung der Dissoziationsrate Ar bzw. zur Erhöhung der Abscheiderate Sauerstoff beigemischt wird.
Da die Anode 7 unter Einwirkung des (nichtdargestellten) Lichtbogens abgetragen wird, besteht sie aus Graphit mit hoher Dichte, der während des Beschichtungsvorgangs nur in geringem Umfang Gas abgibt.

Das Verfahren gemäß der Erfindung wird in der Weise ausgeführt, daß der im Vorratsbehälter 19 gespeicherte Wasserstoff nach Öffnen zumindest eines der Absperrventile 20, 21 über die zugehörige Gasleitung 17 bzw. 18 und den sich anschließenden Gaskanal 7b bzw. 8c unmittelbar in den Lichtbogen eingeleitet und dieser bei nachgeregeltem Abstand zwischen den Elektroden 7 und 8 von der als Kohlenstoffquelle wirksamen Anode 7 gespeist wird.
Vor der Zündung des Lichtbogens wird der Innenraum der Reaktionskammer durch Einschalten der Vakuumpumpe 2 evakuiert und das Substrat 6 mittels der Heizeinheit 5a auf eine Temperatur oberhalb von 400 °C aufgeheizt.

Die nach Zünden des Lichtbogens aus diesem austretenden Ionen werden unter Einwirkung des bezüglich der Anode 7 negativen Potentials (hervorgerufen durch die Leitung 15) in Richtung auf die zu beschichtende Oberfläche 6a des Substrats beschleunigt und schlagen sich dort als harte Kohlenstoffmodifikation, vorzugsweise in Gestalt einer Diamantschicht, nieder.
Um eine Schichtbildungsgeschwindigkeit in der Größenordnung von einem Mikrometer/Minute erreichen zu können, beträgt der insgesamt über eine Elektrode bzw. beide Elektroden in die Reaktorkammer 1 zugeführte Volumenstrom an Wasserstoff mehr als 100 cm³/min.

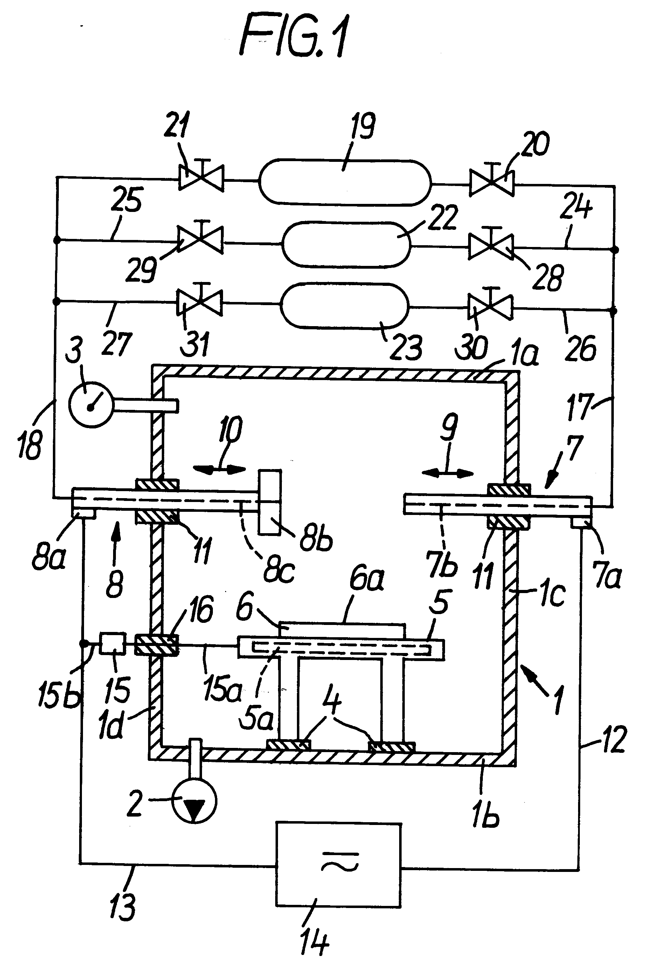

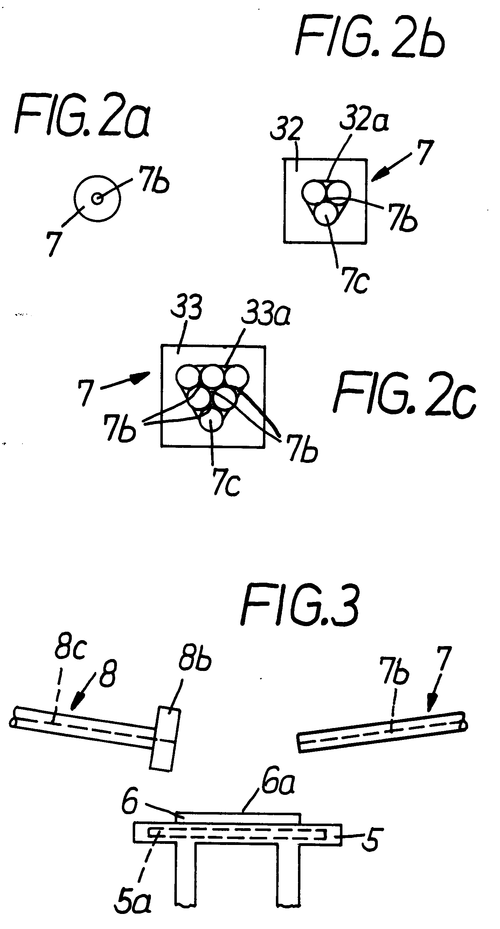

In ihrer einfachsten Ausführungsform ist jede Elektrode - beispielsweise die in Fig. 3a dargestellte Anode 7 - mit einem Gasführungskanal 7b in Gestalt einer Längsbohrung ausgestattet. Abhängig vom Elektrodendurchmesser und/oder bei Verwendung schwer zu bearbeitenden Graphits als Elektrodenwerkstoff läßt sich ein derartiger Gaskanal unter Umständen nicht oder nur mit erheblichem Aufwand herstellen. Es bietet sich daher gegebenenfalls an, die Anode 7 (wie in Fig. 2b und 2c beispielhaft dargestellt) und gegebenenfalls auch die Kathode 8 (vgl . dazu Fig. 1) aus mehreren eine Packung bildenden Stäben zusammenzusetzen.
Bei Verwendung dreier Stäbe 7c, die mittels einer Spannplatte oder mehrerer in Elektrodenlängsrichtung aufeinanderfolgender Spannplatten aneinander abgestützt sind,
entsteht eine Elektrode mit einem mittig zwischen den Stäben 7c verlaufenden Gaskanal 7b (Fig. 2b).

Die zumindest eine Spannplatte 32 weist dabei eine an die Außenkontur der Stäbe 7c angepaßte Öffnung 32a auf.

Bei der Ausführungsform gemäß Fig. 2c entsteht die beispielhaft dargestellte Anode 7 dadurch, daß unter Einwirkung zumindest einer Spannplatte 33 mit angepaßter Öffnung 33a sechs Stäbe 7c gegenseitig aneinander abgestützt werden. Diese schließen miteinander vier Gaskanäle 7b ein. Der damit erzielte Vorteil besteht darin, daß die betreffende Elektrode eine größere Anzahl Gaskanäle aufweist, die gegebenenfalls unabhängig voneinander mit verschiedenen Gasen (Wasserstoff sowie Ar und/oder O₂) beaufschlagt werden können.
Selbstverständlich kann die Kathode in entsprechender Weise aus mehreren eine Packung bildenden Stäben zusammengesetzt sein, dies allerdings mit der Maßgabe, daß ihr der Anode zugewandter Bereich eine erheblich größere Fläche aufweist als diese.

Der bei Aufrechterhaltung des Lichtbogens zwischen den Elektroden 7 und 8 ablaufende Beschichtungsvorgang läßt sich dadurch beeinflussen, daß die Elektroden nicht (wie in Fig. 1 dargestellt) miteinander fluchten, sondern zueinander in Richtung auf das Substrat 6 bzw. die zu beschichtende Oberfläche 6a schräggestellt sind.

Eine derartige Ausführungsform - bei welcher die Elektroden 7 und 8 - vom Substrat 6 her gesehen - miteinander einen Winkel größer als 180 ° einschließen, ist in Fig. 3 angedeutet. Durch die mit der Schrägstellung der Elektroden 7 und 8 verbundene Verformung des Lichtbogens führt dazu, daß die Partikel den Lichtbogen in verstärktem Umfang in Richtung auf die Substrat-Oberfläche 6a verlassen.

Der mit der Erfindung erzielte Vorteil besteht insbesondere darin, daß sich bei verbesserter Steuerungsmöglichkeit des Verfahrens mit hoher Schichtbildungsgeschwindigkeit insbesondere auch Diamantschichten erzeugen lassen.

## Patentansprüche

1. Verfahren zur Erzeugung von Schichten aus harten Kohlenstoffmodifikationen, insbesondere Diamantschichten, unter Einsatz eines Kohlenstoff enthaltenden Mittels mittels eines unter Vakuum zwischen zwei Elektroden gezundeten Gleichstrom-Lichtbogens, dem Wasserstoff zugeführt wird, wobei die Elektroden sich bezüglich des Lichtbogens gegenüberliegen, **dadurch** **gekennzeichnet**, daß der Wasserstoff durch zumindest eine der beiden Elektroden hindurch unmittelbar eingeleitet und der Lichtbogen bei nachgeregeltem Elektrodenabstand gleichzeitig von der als Kohlenstoffquelle wirksamen Anode gespeist wird.

2. Verfahren nach Anspruch 1, dadurch gekennzeichnet, daß der Lichtbogen derart ausgebildet wird, daß er eine Krümmung in Richtung auf das zu beschichtende Substrat aufweist.

3. Verfahren nach zumindest einem der vorhergehenden Ansprüche, gekennzeichnet durch eine derartige Einstellung des Lichtbogens, die eine Dissoziation des Wasserstoffs von mindestens 50 % zur Folge hat.

4. Verfahren nach zumindest einem der vorhergehenden Ansprüche, dadurch gekennzeichnet, daß der Volumenstrom des insgesamt zugeführten Wasserstoffs zwischen 20 und 2000 cm³/min. beträgt.

5. Verfahren nach zumindest einem der vorhergehenden Ansprüche, dadurch gekennzeichnet, daß die Elektroden bei einer Spannung zwischen 70 und 24 V von einem Strom in der Größe zwischen 8 und 70 A durchflossen werden.

6. Verfahren nach zumindest einem der vorhergehenden Ansprüche, dadurch gekennzeichnet, daß die Elektroden mit einer gepulsten Gleichspannung beaufschlagt werden.

7. Verfahren nach zumindest einem der vorhergehenden Ansprüche, dadurch gekennzeichnet, daß dem Wasserstoff vor dem Eintritt in den Lichtbogen die Dissoziationsrate erhöhende Gase beigemischt werden.

8. Verfahren nach zumindest einem der vorhergehenden Ansprüche, dadurch gekennzeichnet, daß dem Wasserstoff vor dem Eintritt in den Lichtbogen Sauerstoff oder Sauerstoffverbindungen beigemischt werden.

9. Verfahren nach zumindest einem der vorhergehenden Ansprüche, dadurch gekennzeichnet, daß das Substrat auf Temperaturen von allenfalls 1000 °C aufgeheizt wird.

10. Verfahren nach zumindest einem der vorhergehenden Ansprüche, dadurch gekennzeichnet, daß die zu beschichtende Oberfläche des Substrats mit energiereichen Teilchen beschossen wird.

11. Verfahren nach zumindest einem der vorhergehenden Ansprüche, dadurch gekennzeichnet, daß die aus dem Lichtbogen austretenden Teilchen durch eine in Richtung auf das Substrat wirksame Vorspannung beschleunigt werden.

12. Verfahren nach Anspruch 11, dadurch gekennzeichnet, daß das Substrat während des Beschichtungsvorgangs auf einem bezüglich der Anode unterschiedlichen Potential gehalten wird.

13. Vorrichtung zur Erzeugung von Schichten aus harten Kohlenstoffmodifikationen, insbesondere Diamantschichten, unter Einsatz eines Kohlenstoff enthaltenden Mittels, mit einer eine Unterdruckquelle aufweisenden Reaktionskammer, in der ein Elektrodenpaar zur Erzeugung eines Gleichstrom-Lichtbogens mit sich bezüglich desselben gegenüberliegenden Elektroden und eine Halterung für ein zu beschichtendes Substrat angeordnet sind, und mit einer Gaszuführung, über welche dem Lichtbogen Wasserstoff zuführbar ist, zur Durchführung des Verfahrens nach zumindest einem der vorhergehenden Anspüche,
**gekennzeichnet** durch folgende Merkmale:
- zumindest eine der beiden Elektroden (7 bzw. 8) des des Elektrodenpaares, nämlich die Anode (7), besteht aus Graphit;
- zumindest eine der Elektroden (7 bzw. 8) ist derartig ausgebildet, daß der Wasserstoff durch sie hindurch in den Lichtbogen eingeleitet werden kann;
- die Elektroden (7, 8) sind in der Weise ausgestaltet, daß die Anode (7) unter Einwirkung des Lichtbogens abgetragen wird;
- der Elektrodenabstand ist über eine Nachregelung zumindest schrittweise aufrechterhaltbar.

14. Vorrichtung nach Anspruch 13, dadurch gekennzeichnet, daß die Kathode (8) in dem der Anode (7) zugewandten Bereich eine zumindest um das Dreifache größere Fläche aufweist als letztere.

15. Vorrichtung nach zumindest einem der vorhergehenden Ansprüche 13 bis 14, dadurch gekennzeichnet, daß zumindest die Anode (7) aus Graphit mit hoher Dichte besteht und derart beschaffen ist, daß sie während des Beschichtungsvorgangs eine geringe Gasabgabe aufweist.

16. Vorrichtung nach zumindest einem der vorhergehenden Ansprüche 13 bis 15, dadurch gekennzeichnet, daß die Anode und/oder Kathode vor dem Beschichtungsvorgang ausgeheizt werden.

17. Vorrichtung nach zumindest einem der Ansprüche 13 bis 16, dadurch gekennzeichnet, daß zumindest eine der beiden Elektroden (7 bzw. 8) mit zumindest einem Gaskanal (7b) ausgestattet und über diesen an die Gaszuführung (17 bzw. 18) anschließbar ist.

18. Vorrichtung nach Anspruch 17, dadurch gekennzeichnet, daß zumindest eine der beiden Elektroden (7 bzw. 8) aus mehreren eine Packung bildenden Stäben (7c) zusammengesetzt ist, zwischen denen der zumindest eine Gaskanal (7b) verläuft.

19. Vorrichtung nach Anspruch 18, dadurch gekennzeichnet, daß die Packung aus drei Stäben (7c) besteht.

20. Vorrichtung nach zumindest einem der Ansprüche 13 bis 19, dadurch gekennzeichnet, daß die Elektroden (7, 8) zueinander in Richtung auf das Substrat (6) schräg gestellt sind.

21. Vorrichtung nach zumindest einem der Ansprüche 13 bis 20, dadurch gekennzeichnet, daß die Reaktionskammer (1) mit einer Teilchenquelle ausgestattet ist, mittels welcher die Substrat-Oberfläche (6a) mit energiereichen Teilchen beaufschlagt werden kann.

22. Vorrichtung nach zumindest einem der Ansprüche 13 bis 21, dadurch gekennzeichnet, daß die Gaszuführung (17 bzw. 18) an eine Mischeinheit anschließbar ist, über welche zusätzlich den Beschichtungsvorgang beeinflussende Gase beigemischt werden können.

## Claims

1. Process for the production of hard carbon layers, in particular diamond layers, using a carbon-containing medium by means of a d.c. arc ignited between two electrodes in a vacuum, to which hydrogen is supplied, said electrodes being positioned opposite one another relative to the arc, characterised in that the hydrogen is passed directly through at least one of the two electrodes and with a readjusted distance between electrodes, the arc is fed by the anode acting as carbon source.

2. Process according to Claim 1, characterised in that the arc is structured in such a way that it is curved towards the substrate to be coated.

3. Process according to at least one of the preceding claims, characterised by such an adjustment of the arc, which results in a dissociation of the hydrogen of at least 50%.

4. Process according to at least one of the preceding claims, characterised in that the volumetric flow of the hydrogen supplied overall lies between 20 and 2000 cm³/min.

5. Process according to at least one of the preceding claims, characterised in that, at a voltage of between 70 and 24 V, a current of between 8 and 70 A is passed through the electrodes.

6. Process according to at least one of the preceding claims, characterised in that the electrodes are supplied with a pulsed d.c. voltage.

7. Process according to at least one of the preceding claims, characterised in that gases increasing the dissociation rate are added to the hydrogen before entry into the arc.

8. Process according to at least one of the preceding claims, characterised in that oxygen or oxygen compounds are added to the hydrogen before entry into the arc.

9. Process according to at least one of the preceding claims, characterised in that the substrate is heated to temperatures of at most 1000°C.

10. Process according to at least one of the preceding claims, characterised in that the surface of the substrate to be coated is bombarded with energy-rich particles.

11. Process according to at least one of the preceding claims, characterised in that the particles discharging from the arc are accelerated by a bias voltage applied onto the substrate.

12. Process according to Claim 11, characterised in that the substrate is maintained at a potential varying relative to the anode during the coating process.

13. Apparatus for the production of hard carbon layers, in particular diamond layers, using a carbon-containing medium, having a reaction chamber with an under-pressure source, in which a pair of electrodes is arranged to generate a d.c. arc with electrodes positioned opposite one another relative thereto and a mounting is provided for a substrate to be coated, and having a gas supply, through which hydrogen may be fed to the arc, for carrying out the process according to at least one of the preceding claims, characterised by the following features:
- at least one of the two electrodes (7 or 8) of said pair of electrodes, namely the anode (7), is made of graphite;
- at least one of the electrodes (7 or 8) is structured in such a way that the hydrogen may be passed through it into the arc;
- the electrodes (7, 8) are structured such that the anode (7) is degraded by the action of the arc;
- the distance between electrodes may be maintained at least intermittently by a readjustment.

14. Apparatus according to Claim 13, characterised in that in the area facing the anode (7), the cathode (8) has a surface area at least three times as large as that of the anode.

15. Apparatus according to at least one of the preceding Claims 13 to 14, characterised in that at the least the anode (7) is made of high-density graphite and is structured in such a way that its gas discharge during the coating process is low.

16. Apparatus according to at least one of the preceding Claims 13 to 15, characterised in that the anode and/or cathode are heated before the coating process.

17. Apparatus according to at least one of Claims 13 to 16, characterised in that at least one of the two electrodes (7 or 8) is provided with at least one gas duct (7b) and may be connected to the gas supply (17 or 18) by this.

18. Apparatus according to Claim 17, characterised in that at least one of the two electrodes (7 or 8) is composed from several rods (7c) forming a bundle, between which at least one gas duct (7b) runs.

19. Apparatus according to Claim 18, characterised in that the bundle is made up of three rods (7c).

20. Apparatus according to at least one of Claims 13 to 19, characterised in that the electrodes (7, 8) are arranged at an angle to one another in the direction of the substrate (6).

21. Apparatus according to at least one of Claims 13 to 20, characterised in that the reaction chamber (1) is provided with a particle source by means of which the surface (6a) of the substrate may be bombarded with energy-rich particles.

22. Apparatus according to at least one of Claims 13 to 21, characterised in that the gas supply (17 or 18) may be connected to a mixer unit, by means of which gases additionally influencing the coating process may be mixed.

## Revendications

1. Procédé pour la production de couches de variétés dures de carbone, en particulier de couches de diamant, en mettant en oeuvre un milieu contenant du carbone, au moyen d'un arc électrique à courant continu allumé entre deux électrodes sous vide, auquel on envoie de l'hydrogène, les électrodes étant placées de part et d'autre de l'arc électrique, caractérisé en ce que l'hydrogène est introduit directement au travers d'au moins l'une des deux électrodes, et en ce que l'arc électrique, avec un écartement d'électrodes réajusté, est alimenté en même temps par une anode agissant comme source de carbone.

2. Procédé suivant la revendication 1, caractérisé en ce que l'arc électrique est réalisé de façon à présenter une courbure dans la direction du substrat à recouvrir.

3. Procédé suivant au moins l'une des revendications précédentes, caractérisé par un réglage de l'arc électrique ayant pour effet une dissociation d'au moins 50 % de l'hydrogène.

4. Procédé suivant au moins l'une des revendications précédentes, caractérisé en ce que le débit volumique de la totalité de l'hydrogène alimenté est compris entre 20 et 2000 cm³/min.

5. Procédé suivant au moins l'une des revendications précédentes, caractérisé en ce que, pour une tension comprise entre 70 et 24 V, les électrodes sont traversées par un courant d'une grandeur comprise entre 8 et 70 A.

6. Procédé suivant au moins l'une des revendications précédentes, caractérisé en ce que les électrodes sont alimentées par une tension continue pulsée.

7. Procédé suivant au moins l'une des revendications précédentes, caractérisé en ce que des gaz augmentant la proportion dissociée sont mélangés à l'hydrogène avant l'entrée dans l'arc électrique.

8. Procédé suivant au moins l'une des revendications précédentes, caractérisé en ce que de l'oxygène ou des composés oxygénés sont mélangés à l'hydrogène avant l'entrée dans l'arc électrique.

9. Procédé suivant au moins l'une des revendications précédentes, caractérisé en ce que le substrat est chauffé en tout au plus à des températures de 1000 °C.

10. Procédé suivant au moins l'une des revendications précédentes, caractérisé en ce que la surface externe du substrat à recouvrir est soumise à un bombardement par des particules à haute énergie.

11. Procédé suivant au moins l'une des revendications précédentes, caractérisé en ce que les particules sortant de l'arc électrique sont accélérées par une tension préliminaire agissant en direction du substrat.

12. Procédé suivant la revendication 11, caractérisé en ce que le substrat est maintenu, pendant l'opération de recouvrement, à un potentiel différent de celui de l'anode.

13. Dispositif pour la producticn de couches de variétés dures de carbone, en particuiier de couches de diamant, en mettant en oeuvre un milieu contenant du carbone, comportant une chambre de réaction présentant une source en dépression, chambre dans laquelle est disposé un couple d'électrodes pour réaliser un arc électrique à courant continu avec des électrodes en position opposée par rapport à celui-ci et une fixation pour un substrat- à recouvrir, et comportant une alimentation en gaz, permettant l'alimentation en hydrogène de l'arc électrique, pour mettre en oeuvre le procédé suivant au moins l'une des revendications précédentes, caractérisé par les caractéristiques suivantes:
- au moins l'une des deux électrodes (respectivement 7 et 8) du couple d'électrodes, c'est-à-dire l'anode (7), est constituée de graphite,
- au moins l'une des électrodes (respectivement 7 et 8) est constituée de telle façon que l'hydrogène peut être introduit dans l'arc électrique au travers d'elle,
- les électrodes (7, 8) sont conçues de telle façon que l'anode (7) soit érodée sous l'action de l'arc électrique,
- la distance des électrodes peut être maintenue correcte par un réajustement, au moins pas à pas.

14. Dispositif suivant la revendication 13, caractérisé en ce que la cathode (8) présente, dans la zone tournée vers l'anode (7), une surface au moins trois fois plus grande que cette dernière.

15. Dispositif suivant au moins l'une quelconque des revendications 13 à 14, caractérisé en ce qu'au moins l'anode (7) est constituée de graphite à haute densité et est conçue de façon à présenter, pendant l'opération de recouvrement, une faible émission de gaz.

16. Dispositif suivant au moins l'une quelconque des revendications 13 à 15, caractérisé en ce que l'anode et/ou la cathode sont chauffées avant l'opération de recouvrement.

17. Dispositif suivant au moins l'une quelconque des revendications 13 à 16, caractérisé en ce qu'au moins l'une des deux électrodes (respectivement 7 et 8) est conçue avec au moins un canal d'arrivée de gaz (7b) et peut être raccordée, par celui-ci, à l'alimentation en gaz (respectivement 17 et 18).

18. Dispositif suivant la revendication 17, caractérisé en ce qu'au moins l'une des deux électrodes (respectivement 7 ou 8) est constituée par l'assemblage de plusieurs barreaux (7c) formant un paquet, entre lesquels passe au moins un canal d'arrivée de gaz (7b).

19. Dispositif suivant la revendication 18, caractérisé en ce que le paquet est constitué de trois barreaux (7c).

20. Dispositif suivant au moins l'une quelconque des revendications 13 à 19, caractérisé en ce que les électrodes (7, 8) sont disposées inclinées l'une par rapport à l'autre en direction du substrat (6).

21. Dispositif suivant au moins l'une quelconque des revendications 13 à 20, caractérisé en ce que la chambre de réaction (1) est conçue avec une source de particules, au moyen de laquelle la surface externe (6a) du substrat peut être soumise des particules à haute énergie.

22. Dispositif suivant au moins l'une quelconque des revendications 13 à 21, caractérisé en ce que l'alimentation en gaz (respectivement 17 et 18) peut être raccordée à une unité de mélange au moyen de laquelle des gaz agissant sur l'opération de recouvrement peuvent être ajoutés en mélange.
